# EUROPEAN PATENT SPECIFICATION

(11) **EP 3 478 036 B1**
(45) Date of publication and mention of the grant of the patent: **26.05.2021**
(21) Application number: 18197269.6
(22) Date of filing: 27.09.2018
(51) Int. Cl.: H05K 3/40, B21K 1/62, F16B 5/08, F16B 19/06, F16B 1/00, H05K 1/03, H05K 3/34, H05K 1/11

(54) **LED LIGHT SOURCE MODULE AND MANUFACTURING METHOD**
LED-LICHTQUELLENMODUL UND HERSTELLUNGSVERFAHREN
MODULE DE SOURCE LUMINEUSE À LED ET PROCÉDÉ DE FABRICATION

(30) Priority: 30.10.2017 CN 201711041838
(43) Date of publication of application: 01.05.2019
(73) Proprietor: Self Electronics Co., Ltd., Ningbo City, Zhejiang 315103 (CN); SELF ELECTRONICS Germany GmbH, 51149 Köln (DE); Lin, Wanjiong, Ningbo City, Zhejiang 315103 (CN)
(72) Inventor: LIU, Xiaoyun, Ningbo, 315103 (CN); DONG, Jianguo, Ningbo, 315103 (CN); ZHAO, Wenzhan, Ningbo, 315103 (CN); HUANG, Tonghua, Ningbo, 315103 (CN); TONG, Lihong, Ningbo, 315103 (CN)
(74) Representative: 2K Patentanwälte Blasberg Kewitz & Reichel

(56) References cited:
- WO-A2-2011/013966
- CN-U- 205 927 730
- JP-A- 2016 219 557

## Description

### CROSS-REFERENCE TO A RELATED APPLICATION

This application claims priority to a Chinese Patent Application No. CN 201711041838.5, filed on October 30, 2017.

### FIELD OF THE TECHNOLOGY

The present invention relates to lighting system, with particular emphasis on an LED light source module and manufacturing method capable of providing specific illumination effect.

### BACKGROUND

In general daily life, various lighting devices can be seen everywhere, such as fluorescent lamps, street lamps, table lamps, art lamps, and the like. In the above lighting apparatus, a tungsten filament bulb is conventionally used as a light source. In recent years, due to the rapid development of technology, light-emitting diodes (LEDs) have been used as sources of illumination.

In addition to lighting equipment, for general traffic signs, billboards, lights, etc., also use LEDs as a light source. As mentioned above, the use of light-emitting diodes as light-emitting sources has the advantages of power saving and greater brightness, so it has gradually become common in use.

With the development of lighting technology, people are increasingly demanding light sources, especially for strip lamps. The strip light is made by setting the electrical connection of several LED chips on a strip circuit board. However, in order to improve the applicability of the power supply, for example, the output of the power supply is 36 volts, but the rated voltage of the strip lamp is 12 volts, or 24 volts, etc., at this time, the strip lamp needs to be provided with some electronic components to rotate the input voltage of 36 volts to 12 or 24 volts, and the electronic components and the LED chips are electrically connected to the two sides of the circuit board, that is, the double panel. The connection method of the double-sided circuit board generally uses a copper sinking process, that is, Open a through-hole between the two sides of the circuit board, and then copper as a wire is deposited in the through-hole, thereby the electronic components on both sides of the circuit board are electrically connected.

Then, as the requirements of environmental protection become more and more strict, the heavily-polluted process of the copper-plating process makes the manufactured circuit board expensive, and because the temperature required in the copper sinking process is high, The circuit board suitable for the copper sinking process requires at least a relatively expensive substrate such as a fiberglass cloth, and is not a cheaper substrate such as a composite board. This also makes the price of existing double panels higher, which is not conducive to cost reduction and product competitiveness.

Patent publication JP 2016 219557 describes a rivet and a double sided printed circuit board, the rivet is soldered to establish a connection between wirings on both sides of the printed circuit board.

Patent publication WO 2011/013966 A2 describes a rivet inserted in a hole of the printed circuit board that is thermally connected to a LED and is being used as a localised heat-sink.

Patent publication CN 205 927 730 U concerns a pick and place machine that uses a suction nozzle to pick up, hold and place screws.

### SUMMARY OF THE INVENTION

Therefore, the present invention provides an LED light source module and manufacturing method capable of providing specific illumination effect to solve the above problem.

An LED light source module comprises a double-sided circuit board and at least one rivet electrically connected to two sides of the double-sided circuit board. The double-sided circuit board comprises a circuit substrate and at least one first wiring layout disposed on one side of the circuit substrate, and at least one second wiring layout disposed on the other side of the circuit board, and a perforation formed between the first wiring layout and the second wiring layout. The rivet is disposed in the perforation to electrically connect the first and second wiring layouts. The rivet comprises a nail head, a shank, and a transition section connecting the nail head and the shank. The length of the nail head in the cross section along the thickness direction of the circuit substrate is greater than the width of the shank, and the transition section is a trapezoid, the short side of the trapezoid is connected to the shank, the length of the long side of the trapezoid is smaller than the length of the nail head. The nail head is electrically connected to the first wiring layout, and the shank is electrically connected to the second wiring layout by soldering. Further, the length of the shank is greater than the thickness of the circuit substrate, the width of the shank is smaller than the diameter of the perforation, the free end of the shank is tapered.

Advantageously, the circuit substrate is made of a composite board which is composited from paper material and fiber material.

Advantageously, the rivet is made of metal.

Advantageously, the LED light source module further includes a plurality of LED chips electrically connected to one side of the double-sided circuit board, and a plurality of electronic components electrically connected to the other side of the double-sided circuit board, the LED chips is electrically connected to the first wiring layout, and the electronic component is electrically connected to the second wiring layout.

A LED light source module manufacturing method, which comprises the following steps:
providing a double-sided circuit board of the LED light source module as described in claims 1 to 4
providing a patch machine, the patch machine including at least one nozzle mounting device, at least one suction nozzle mounted on the nozzle mounting device, and a circuit board placing table, the suction nozzle including a hollow cylinder, and a step portion disposed on the free end of the hollow cylinder, on a section along the axis of the hollow cylinder, the length of the step portion is equivalent to the length of the nail head;
providing electronic components, rivets, and LED chips to be soldered to the double-sided circuit board, and solder paste used for soldering the electronic components, rivets, LED chips, and first and second wiring layouts;
placing the double-sided circuit board on the circuit board placing table;
the patch machine is used to lay the solder paste on the side of the double-sided circuit board on which the second wiring layout is disposed and attach the electronic component;
performing reflow soldering to electrically connect the electronic component to the second wiring layout;
laying the solder paste on the side of the double-sided circuit board on which the first wiring layout is disposed by the patch machine, and attaching the LED chip while sucking the rivet through the suction nozzle, and inserting the rivet into the perforation;
performing reflow soldering to electrically connect the LED chip to the first wiring layout, and electrically connecting and fixing the nail head of the rivet to the first wiring layout;
repair welding the shank of the rivet protruding from the side of the second wiring layout to electrically connect the rivet and the second wiring layout to complete the assembly of the LED light source module.

Advantageously, the repair welding is done by hand.

Advantageously, the height of the step portion in the axial direction of the hollow cylinder is equal to the height of the nail head.

Compared with the prior art, the double-sided circuit board of the LED light source module of the present invention is electrically connected to the first and second wiring layouts and through the rivet, and does not use the heavily contaminated copper sink.

The process can reduce the cost of pollution control, and at the same time, when assembling the rivet, the high temperature like the copper sink process is not required, so that the circuit substrate of a lower-grade material, such as a composite substrate containing a paper base, can be used.

Therefore, the cost can be reduced in terms of materials, and the overall cost of the LED light source module can be reduced to improve the competitiveness of the lamp having the LED light source module.

### DETAILED DESCRIPTION OF THE DRAWINGS

The drawings described herein are intended to promote a further understanding of the present invention, as follows:
FIG. 1 is a schematic structural view of an LED light source module according to the present invention.
FIG. 2 is a cross-sectional structural view taken along line A-A of the LED light source module of FIG. 1.
FIG. 3 is a schematic structural view of the assembly using a placement machine of the LED light source module of FIG. 1.
FIG.4 is a schematic cross-sectional structural view of a suction nozzle used in the placement machine.
FIG. 5 is a flow chart showing the manufacture of the LED light source module of FIG. 1.

### DESCRIPTION OF THE PREFERRED EMBODIMENTS

The present application is illustrated by way of the following detailed description based on of the accompanying drawings. It should be noted that illustration to the embodiment in this application is not intended to limit the invention.

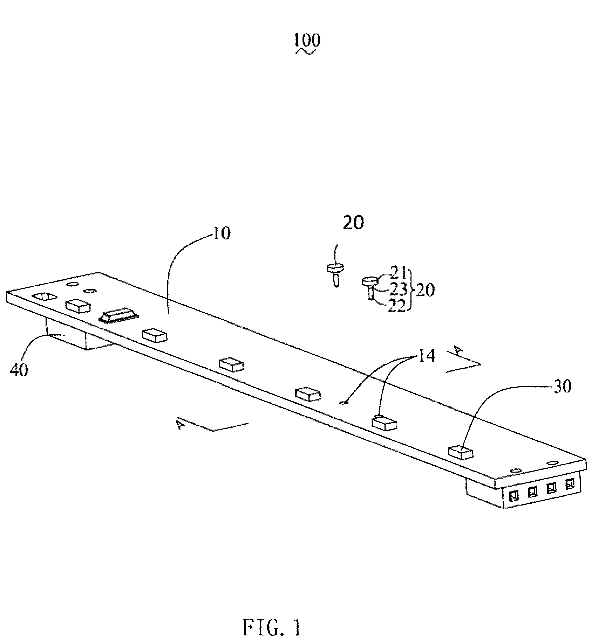

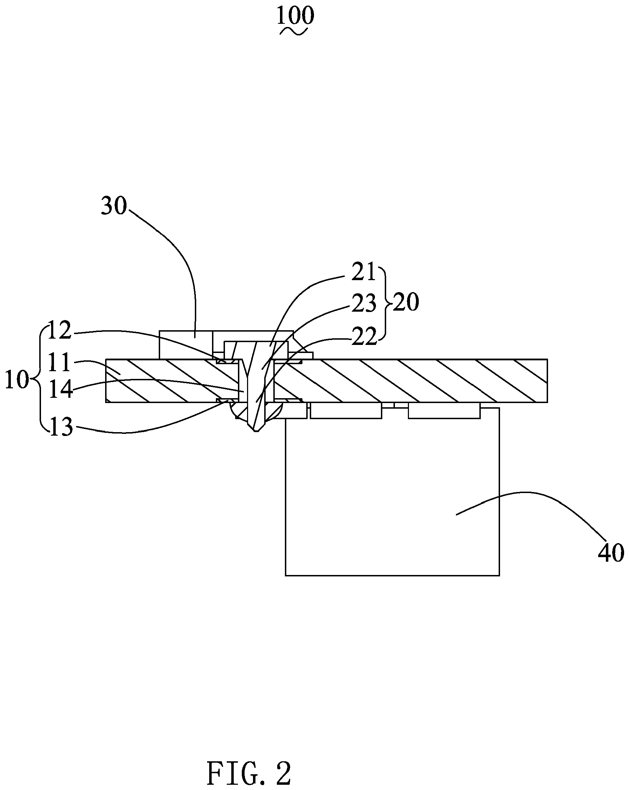

Please refer to FIG. 1 to FIG. 2, which are schematic structural diagrams of an LED light source module 100 according to the present invention. The LED light source module 100 includes a double-sided circuit board 10 and at least one rivet 20 electrically connected to two sides of the double-sided circuit board 10, and a plurality of LED chips 30 are electrically connected to one side of the double-sided circuit board 10, and a plurality of electronic components 40 electrically connected to the other side of the double-sided circuit board 10 are provided. It is conceivable that the LED light source module 100 further includes other functional modules, such as a plug-in assembly, a series-connected component, etc., which are well known to those skilled in the art and will not be described in detail herein.

The double-sided circuit board 10 includes a circuit substrate 11, at least one first wiring layout 12 disposed on one side of the circuit substrate 11, and at least one second wiring layout disposed on the other side of the circuit substrate 11. And a perforation 14 formed between the first wiring layout 12 and the second wiring layout 13. The circuit substrate 11 may be made of a composite board which may be composited from paper material and fiber material, such as a series of epoxy glass cloth paper sheets. The fibrous material may be a glass cloth, as well as synthetic fibers or the like. Of course, the circuit substrate 11 can also be a higher-grade glass cloth substrate that is not doped with paper, or the like. The first wiring layout 12 has the same structure and working principle as the second wiring layout 13, and only the first wire layout 12 is taken as an example. First, a layer of copper is arranged on the circuit substrate 11 through the rolling copper foil process or electrolytic copper foil process, then, the desired circuit connection line is formed by etching the process, and finally an insulating layer is coated on the surface of the circuit substrate provided with the copper foil, and the position where the electronic component needs to be disposed is exposed, so that the subsequent process will be electronic components are disposed on the first wiring layout 12 for electrical connection purposes. The first and second wiring layouts 12 and 13 may have the same layout design or different layout designs. In this embodiment, the first and second wiring layouts 12 and 13 have different layout designs to electrically connect different electronic components. It can be understood that the first and second wiring layouts 12 and 13 may have one or a plurality of strips as needed. In the embodiment, the double-sided circuit board 10 is provided with two first wiring layouts 12 and two second wiring layouts 13 on both sides of the circuit substrate 11 to form positive and negative circuits. The perforation 14 is defined between the first and second wiring layouts 12 and 13, that is, the perforation 14 sequentially passes through the first wiring layout 12, the circuit substrate 11, and the second wiring layout 13. It is conceivable that the perforations 14 cannot be opened in a position without the first and second wiring layouts 12, 13. The position of the perforation 14 can be set according to actual needs. Specifically, in the embodiment, the perforation 14 is disposed at the free ends of the first and second wiring layouts 12 and 13. The number of the perforations 14 is determined by the number of the first and second wiring layouts 12, 13. In the present embodiment, since the first and second wiring layouts 12 and 13 are each two, the perforations 14 also have two.

The rivet 20 includes a nail head 21, a shank 22, and a transition section 23 connecting the nail head 21 and the shank 22. The structural size of the rivet 20 is very important, so its structural size not only affects the reliability of the electrical connection, but also affects the reliability and automation performance of the production process. Since the rivet 20 acts as an electrical connection, the rivet 20 should be made of metal. In the present embodiment, the rivet 20 is made of copper. The length of the nail head 21 in the cross section along the thickness direction of the circuit substrate 11 is larger than the width of the shank 22, and the transition section 23 is a trapezoidal shape. The short side of the trapezoid is connected to the shank 22. The length of the long side of the trapezoid is smaller than the length of the nail head 21. The nail head 21 is electrically connected to the first wiring layout 12, and the shank 22 is electrically connected to the second wiring layout 13 by soldering. In order to weld the shank 22 and the second wiring layout 13 by soldering tin, the length of the shank 22 is greater than the thickness of the circuit substrate 11. The nail head 21 is circular in this embodiment in a section perpendicular to the thickness direction of the circuit substrate 11. It is conceivable that the shape of the nail head may also be other shapes such as a square or the like. However, it can be understood that the round nail head 21 is most advantageous for industrialization.

For industrialization, the rivet 20 is assembled into the perforation 14 of the double-sided circuit board 10, the rivet 20 is generally sucked up and inserted into the perforation 14 through the patch machine and the suction nozzle of the patch machine. The patch machine is a prior art and is well known to those skilled in the art and will not be described herein. Therefore, the width of the shank 22 is smaller than the diameter of the perforation 14 in order to be compatible with the error of the patch machine within a certain range, that is, when the error of the patch machine is within the range of the difference between the width of the shank 20 and the diameter of the perforation 14, the shank 20 can be inserted into the perforation 14. The purpose of providing the transition portion 23 is to strengthen the connection strength between the nail head 21 and the shank 22, and at the same time, under the action of gravity and the unavoidable jitter of the double-sided circuit board 10 during the operation of the patch machine, Advantageously, the axis of the shank 22 coincides with the axis of the perforation 14, thereby facilitating the reliability of the electrical connection of the nail head 21 of the rivet 20 to the first wiring layout 12. Further, in order to smoothly insert the rivet 20 into the perforation 14, the free end of the shank 22 is tapered.

The LED chip 30 is a prior art, which is also placed on the first wiring layout 12 of the double-sided circuit board 10 together with the rivet 20 by a patch machine, and then the LED chip 30 is soldered to the first wiring layout 12 by reflow soldering.

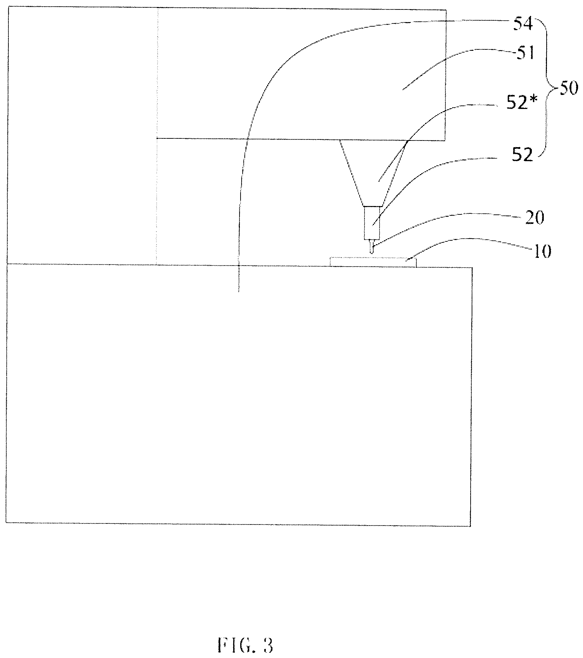

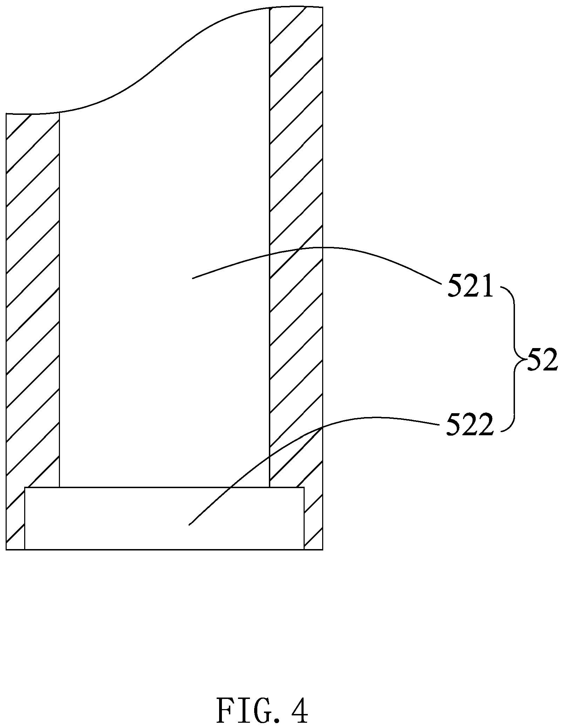

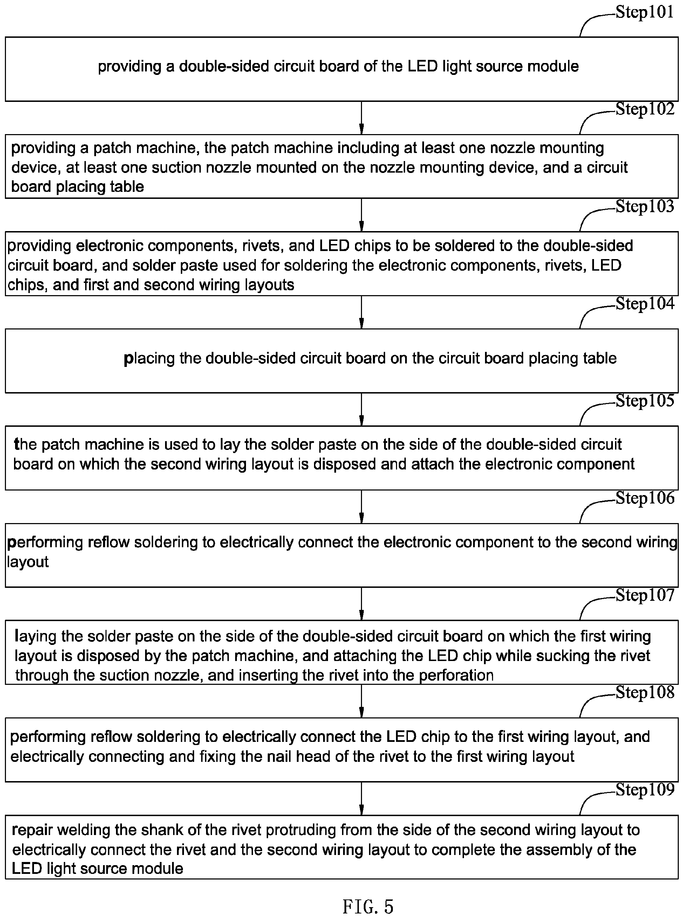

The electronic component 40 is disposed on the other side of the circuit substrate 11 and electrically connected to the second wiring layout 13 . It is conceivable that the electronic component 40 may include components such as resistors, capacitors, transistors, diodes, etc. for the purpose of decompression shunt, the structure and working principle thereof, and the connection method should be the technology in the art. As far as the personnel are concerned, they will not be explained in detail here.
As shown in FIG. 5, it is a flowchart of a method of manufacturing the LED light source module 100. The manufacturing method of the LED light source module 100 includes the following steps:
Step 101: Providing a double-sided circuit board 10 of the LED light source module 100 as described above;
Step 102: Providing a patch machine 50, as shown in FIG. 3, the patch machine 50 includes at least one nozzle mounting device 51, at least one suction nozzle 52 mounted on the nozzle mounting device 51, and a circuit board placing table 53. Referring to FIG. 4, the suction nozzle 52 includes a hollow cylinder 521, and a step portion 522 disposed on the free end of the hollow cylinder 521, on a section along the axis of the hollow cylinder 521, the length of the step portion 522 is equivalent to the length of the nail head 21;
Step 103: Providing electronic components 40, rivets 20, and LED chips 30 to be soldered to the double-sided circuit board 10, and solder paste used for soldering the electronic components, rivets, LED chips, and first and second wiring layouts12, 13 (not shown in the figure);
Step 104: Placing the double-sided circuit board 10 on the circuit board placing table 53;
Step 105: The patch machine 50 is used to lay the solder paste on the side of the double-sided circuit board 10 on which the second wiring layout 13 is disposed and attach the electronic component 40;
Step 106: Performing reflow soldering to electrically connect the electronic component 40 to the second wiring layout 13;
Step 107: Laying a solder paste on the side of the double-sided circuit board 10 on which the first wiring layout 12 is disposed by the patch machine 50, and attaching the LED chip 30 while sucking the rivet 20 through the suction nozzle 52,and inserting the rivet 20 into the perforation 14;
Step 108: Performing reflow soldering to electrically connect the LED chip 30 to the first wiring layout 12, and electrically connecting and fixing the nail head 21 of the rivet 20 to the first wiring layout 12;
Step 109: Repair welding the shank 22 of the rivet 20 protruding from the side of the second wiring layout 13 to electrically connect the rivet 20 and the second wiring layout 13 to complete the assembly of the LED light source module 100.

In step 109, the repair welding may be done manually or by a machine.

In step 102, the height of the step portion 522 in the axial direction of the hollow cylinder 521 is equivalent to the height of the nail head 21. There are two main ways in which the patch machine 50 can travel, one is a parallel movement type, and the other is a circular movement type. Regardless of the type of travel, the suction nozzle 52 drives the sucked component to move, and the moving speed is faster, and from rest to movement, the sucked component is easily dropped under the action of inertia, especially when the rivet 20 has a small volume. In the present embodiment, the diameter of the nail head 21 of the rivet 20 is only 1.0 mm, and the diameter of the shank 22 is only 0.5 mm. Therefore, the step portion 522 is provided at the free end of the suction nozzle 52. When the nail head 21 is inset into the step portion 52, the nozzle mounting device 51 of the patch machine 50 can be prevented from dropping the rivet 20 during traveling, so that the reliability of processing can be ensured.

Compared with the prior art, the double-sided circuit board 10 of the LED light source module 100 of the present invention is electrically connected to the first and second wiring layouts 12 and 13 through the rivet 20, and does not use the heavily contaminated copper sink. The process can reduce the cost of pollution control, and at the same time, when assembling the rivet, the high temperature like the copper sink process is not required, so that the circuit substrate 11 of a lower-grade material, such as a composite substrate containing a paper base, can be used. Therefore, the cost can be reduced in terms of materials, and the overall cost of the LED light source module 100 can be reduced to improve the competitiveness of the lamp having the LED light source module 100.

## Claims

1. A LED light source module (100), wherein the LED light source module comprises a double-sided circuit board (10) and at least one rivet (20) electrically connected to two sides of the double-sided circuit board, the double-sided circuit board comprising a circuit substrate (11) and at least one first wiring layout (12) disposed on one side of the circuit substrate, and at least one second wiring layout (13) disposed on the other side of the circuit board, and a perforation (14) formed between the first wiring layout and the second wiring layout, the rivet being disposed in the perforation to electrically connect the first and second wiring layouts, the rivet (20) including a nail head (21), a shank (22), and a transition section (23) connecting the nail head and the shank, the length of the shank is greater than the thickness of the circuit substrate, the width of the shank is smaller than the diameter of the perforation, the free end of the shank is tapered, the thickness of the nail head is greater than the width of the shank, and the transition section (23) is a trapezoid , the short side of the trapezoid is connected to the shank, the length of the long side of the trapezoid is smaller than the length of the nail head, the nail head is electrically connected to the first wiring layout, and the shank is electrically connected to the second wiring layout by soldering.

2. The LED light source module as claimed in claim 1, wherein the circuit substrate is made of a composite board which is composited from paper material and fiber material.

3. The LED light source module as claimed in of the preceding claims, wherein the rivet is made of metal.

4. The LED light source module as claimed in of the preceding claims, wherein the LED light source module further includes a plurality of LED chips electrically connected to one side of the double-sided circuit board, and a plurality of electronic components electrically connected to the other side of the double-sided circuit board, the LED chips is electrically connected to the first wiring layout, and the electronic component is electrically connected to the second wiring layout.

5. A LED light source module manufacturing method for providing a double-sided circuit board of the LED light source module as described in claims 1 to 4 the method comprises the following steps:
(102): providing a patch machine (50), the patch machine including at least one nozzle mounting device (51), at least one suction nozzle (52) mounted on the nozzle mounting device, and a circuit board placing table, the suction nozzle including a hollow cylinder (521), and a step portion (522) disposed on the free end of the hollow cylinder, on a section along the axis of the hollow cylinder, the length of the step portion is equivalent to the length of the nail head;
(103): providing electronic components (40), rivets (20), and LED chips (30) to be soldered to the double-sided circuit board, and solder paste used for soldering the electronic components, rivets, LED chips, and first and second wiring layouts;
(104): placing the double-sided circuit board on the circuit board placing table;
(105): the patch machine is used to lay the solder paste on the side of the double-sided circuit board on which the second wiring layout is disposed and attach the electronic component;
(106): performing reflow soldering to electrically connect the electronic component to the second wiring layout;
(107): laying the solder paste on the side of the double-sided circuit board on which the first wiring layout is disposed by the patch machine, and attaching the LED chip while sucking the rivet through the suction nozzle, and inserting the rivet into the perforation;
(108): performing reflow soldering to electrically connect the LED chip to the first wiring layout, and electrically connecting and fixing the nail head of the rivet to the first wiring layout;
(109): soldering the shank of the rivet protruding from the side of the second wiring layout to electrically connect the rivet and the second wiring layout to complete the assembly of the LED light source module.

6. The LED light source module manufacturing method as claimed in claim 5, wherein the soldering is done by hand.

7. The LED light source module manufacturing method as claimed in claim 5 or 6, wherein the height of the step portion in the axial direction of the hollow cylinder is equal to the height of the nail head.

## Patentansprüche

1. LED-Lichtquellenmodul (100), wobei das LED-Lichtquellenmodul eine doppelseitige Leiterplatte (10) und mindestens eine Niete (20) umfasst, die elektrisch mit zwei Seiten der doppelseitigen Leiterplatte verbunden ist, wobei die doppelseitige Leiterplatte ein Schaltungssubstrat (11) und mindestens ein erstes Verdrahtungslayout (12) umfasst, das auf einer Seite des Schaltungssubstrats angeordnet ist, und mindestens ein zweites Verdrahtungslayout (13) umfasst, das auf der anderen Seite der Leiterplatte angeordnet ist, und eine Perforation (14) umfasst, die zwischen dem ersten Verdrahtungslayout und dem zweiten Verdrahtungslayout ausgebildet ist, wobei die Niete in der Perforation angeordnet ist, um das erste und das zweite Verdrahtungslayout elektrisch zu verbinden, wobei die Niete (20) einen Nagelkopf (21), einen Schaft (22) und einen Übergangsabschnitt (23) aufweist, der den Nagelkopf und den Schaft verbindet, wobei die Länge des Schafts größer als die Dicke des Schaltungssubstrats ist, wobei die Breite des Schafts kleiner als der Durchmesser der Perforation ist, wobei das freie Ende des Schafts verjüngt ist, wobei die Dicke des Nagelkopfs größer als die Breite des Schafts ist, und wobei der Übergangsabschnitt (23) ein Trapez ist, wobei die kurze Seite des Trapezes mit dem Schaft verbunden ist, wobei die Länge der langen Seite des Trapezes kleiner ist als die Länge des Nagelkopfes, wobei der Nagelkopf elektrisch mit dem ersten Verdrahtungslayout verbunden ist und der Schaft elektrisch mit dem zweiten Verdrahtungslayout durch Löten verbunden ist.

2. LED-Lichtquellenmodul nach Anspruch 1, wobei das Schaltungssubstrat aus einer Verbundplatte hergestellt ist, die aus Papiermaterial und Fasermaterial zusammengesetzt ist.

3. LED-Lichtquellenmodul nach einem der vorhergehenden Ansprüche, wobei die Niete aus Metall besteht.

4. LED-Lichtquellenmodul nach einem der vorhergehenden Ansprüche, wobei das LED-Lichtquellenmodul ferner eine Vielzahl von LED-Chips, die elektrisch mit einer Seite der doppelseitigen Leiterplatte verbunden sind, und eine Vielzahl von elektronischen Komponenten, die elektrisch mit der anderen Seite der doppelseitigen Leiterplatte verbunden sind, umfasst, wobei die LED-Chips elektrisch mit dem ersten Verdrahtungslayout verbunden sind und die elektronische Komponente elektrisch mit dem zweiten Verdrahtungslayout verbunden ist.

5. Herstellungsverfahren für ein LED-Lichtquellenmodul zum Bereitstellen einer doppelseitigen Leiterplatte des LED-Lichtquellenmoduls, wie in den Ansprüchen 1 bis 4 beschrieben; wobei das Verfahren umfasst die folgenden Schritte:
(102): Bereitstellen einer Patchmaschine (50), wobei die Patchmaschine mindestens eine Düsenbefestigungsvorrichtung (51), mindestens eine Saugdüse (52), die an der Düsenbefestigungsvorrichtung angebracht ist, und einen Leiterplatten-Platzierungstisch aufweist, wobei die Saugdüse einen Hohlzylinder (521) und einen Stufenabschnitt (522) aufweist, der an dem freien Ende des Hohlzylinders auf einem Abschnitt entlang der Achse des Hohlzylinders angeordnet ist, wobei die Länge des Stufenabschnitts der Länge des Nagelkopfes entspricht;
(103): Bereitstellen von elektronischen Komponenten (40), Nieten (20) und LED-Chips (30), die an die doppelseitige Leiterplatte gelötet werden sollen, und von Lötpaste, die zum Löten der elektronischen Komponenten, Nieten, LED-Chips und der ersten und zweiten Verdrahtungsanordnung verwendet wird;
(104): Platzieren der doppelseitigen Leiterplatte auf dem Leiterplatten-Platzierungstisch;
(105): die Patchmaschine wird verwendet, um die Lötpaste auf die Seite der doppelseitigen Leiterplatte aufzutragen, auf der das zweite Verdrahtungslayout angeordnet ist, und das elektronische Bauelement anzubringen;
(106): Durchführen von Reflow-Löten, um das elektronische Bauteil mit dem zweiten Verdrahtungslayout elektrisch zu verbinden;
(107): Aufbringen der Lötpaste auf die Seite der doppelseitigen Leiterplatte, auf der das erste Verdrahtungslayout angeordnet ist, durch die Patchmaschine, und Anbringen des LED-Chips, während die Niete durch die Saugdüse angesaugt wird, und Einsetzen der Niete in die Perforation;
(108): Durchführen von Reflow-Löten, um den LED-Chip mit dem ersten Verdrahtungslayout elektrisch zu verbinden, und elektrisches Verbinden und Befestigen des Nagelkopfes der Niete mit dem ersten Verdrahtungslayout;
(109): Löten des Schaftes der Niete, der aus der Seite der zweiten Verdrahtungsanordnung herausragt, um die Niete und die zweite Verdrahtungsanordnung elektrisch zu verbinden, um die Montage des LED-Lichtquellenmoduls zu vervollständigen.

6. Verfahren zur Herstellung eines LED-Lichtquellenmoduls nach Anspruch 5, wobei das Löten von Hand durchgeführt wird.

7. Herstellungsverfahren für ein LED-Lichtquellenmodul nach Anspruch 5 oder 6, wobei die Höhe des Stufenabschnitts in axialer Richtung des Hohlzylinders gleich der Höhe des Nagelkopfs ist.

## Revendications

1. Un module de source lumineuse à LED (100), le module de source lumineuse à LED comprenant une carte de circuit imprimé double face (10) et au moins un rivet (20) connecté électriquement à deux côtés de la carte de circuit imprimé double face, la carte de circuit imprimé double face comprenant un substrat de circuit (11) et au moins une première disposition de câblage (12) disposée sur un côté du substrat de circuit et au moins un deuxième schéma de câblage (13) disposé sur l'autre côté du substrat de circuit, et une perforation (14) formée entre le premier schéma de câblage et le deuxième schéma de câblage, le rivet étant disposé dans la perforation pour connecter électriquement les premier et deuxième schémas de câblage, dans lequel le rivet (20) comprend une tête de clou (21), une tige (22) et une partie de transition (23) reliant la tête de clou et la tige, la longueur de la tige étant supérieure à l'épaisseur du substrat de circuit, la largeur de la tige étant inférieure au diamètre de la perforation, l'extrémité libre de la tige étant effilée, l'épaisseur de la tête de clou étant supérieure à la largeur de la tige. et dans lequel la partie de transition (23) est un trapèze, le petit côté du trapèze étant connecté à la tige, la longueur du grand côté du trapèze étant inférieure à la longueur de la tête de clou, la tête de clou étant connectée électriquement au premier schéma de câblage et la tige étant connectée électriquement au second schéma de câblage par soudure.

2. Le module de source lumineuse à LED selon la revendication 1, dans lequel le substrat de circuit est fait d'un panneau composite composé de matériau de papier et de matériau de fibre.

3. Le module de source lumineuse à LED selon l'une quelconque des revendications précédentes, dans lequel le rivet est en métal.

4. Le module de source de lumière à LED selon l'une quelconque des revendications précédentes, dans lequel le module de source de lumière à LED comprend en outre une pluralité de puces de LED connectées électriquement à un côté de la carte de circuit imprimé double face et une pluralité de composants électroniques connectés électriquement à l'autre côté de la carte de circuit imprimé double face, dans lequel les puces de LED sont connectées électriquement à la première disposition de câblage et le composant électronique est connecté électriquement à la deuxième disposition de câblage.

5. Un procédé de fabrication d'un module de source lumineuse à LED pour fournir une carte de circuit imprimé double face du module de source lumineuse à LED tel que décrit dans les revendications 1 à 4; le procédé comprenant les étapes suivantes:
(102): fournir une machine de réparation (50), la machine de réparation ayant au moins un dispositif de fixation de buse (51), au moins une buse d'aspiration (52) fixée au dispositif de fixation de buse, et une table de placement de carte de circuit imprimé, la buse d'aspiration ayant un cylindre creux (521) et une partie de pas (522) disposée à l'extrémité libre du cylindre creux sur une partie le long de l'axe du cylindre creux, la longueur de la partie de pas correspondant à la longueur de la tête de clou;
(103): fournir des composants électroniques (40), des rivets (20), et des puces LED (30) à souder sur la carte de circuit imprimé double face, et de la pâte à souder utilisée pour souder les composants électroniques, les rivets, les puces LED, et les premier et second ensembles de câblage;
(104): placer la carte de circuit imprimé double face sur la table de placement de la carte de circuit imprimé;
(105): utiliser la machine à patcher pour appliquer la pâte à souder sur le côté de la carte de circuit imprimé double face sur laquelle est placé le deuxième schéma de câblage, et fixer le composant électronique;
(106): effectuer une soudure par refusion pour connecter électriquement le composant électronique à la seconde disposition de câblage;
(107): application de la pâte à souder sur le côté de la carte de circuit imprimé double face sur lequel est disposé le premier schéma de câblage par la machine à patcher, et fixation de la puce LED tout en aspirant le rivet par la buse d'aspiration, et insertion du rivet dans la perforation;
(108): effectuer une soudure par refusion pour connecter électriquement la puce LED à la première disposition de câblage, et connecter électriquement et fixer la tête de clou du rivet à la première disposition de câblage;
(109) souder la tige du rivet dépassant du côté de la deuxième disposition de câblage pour connecter électriquement le rivet et la deuxième disposition de câblage afin d'achever l'assemblage du module de source lumineuse à LED.

6. Procédé de fabrication d'un module de source lumineuse à LED selon la revendication 5, dans lequel la soudure est effectuée à la main.

7. Procédé de fabrication d'un module de source lumineuse à LED selon la revendication 5 ou 6, dans lequel la hauteur de la partie étagée dans la direction axiale du cylindre creux est égale à la hauteur de la tête de clou.
